(19)

**Europäisches Patentamt**
**European Patent Office**
**Office européen des brevets**

(11) **EP 4 625 823 A1**

(12) **EUROPEAN PATENT APPLICATION**

(43) Date of publication:
**01.10.2025 Bulletin 2025/40**

(21) Application number: **24305471.5**

(22) Date of filing: **28.03.2024**

(51) International Patent Classification (IPC):
**H03M 1/06** *(2006.01)*  **H03M 1/14** *(2006.01)*
**H03M 1/60** *(2006.01)*  **H03M 3/00** *(2006.01)*

(52) Cooperative Patent Classification (CPC):
**H03M 1/0697; H03M 1/145; H03M 1/60; H03M 3/39**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Presto Engineering Group**
**13590 Meyreuil (FR)**

(72) Inventors:
• **RASMUSSEN, Erik Elmer**
  **Copenhagen S (DK)**
• **ESTRUP, George**
  **2800 Kgs. Lyngby (DK)**
• **SUANES-PEREZ, Alejandro**
  **Almería 04878 (ES)**
• **SERRA-GRAELLS, Francesc**
  **08193 Cerdanyola del Vallès (ES)**

(74) Representative: **Germain Maureau**
  **12, rue Boileau**
  **69006 Lyon (FR)**

(54) **ANALOG TO DIGITAL CONVERTER HAVING A HIGH RESOLUTION AND EFFICIENT WITH SMALL CURRENTS**

(57)      The present disclosure relates to a method for converting an input analog signal into an output digital value, the method comprising: applying the input analog signal (Ic) to an integrator (OP1) for an integration period (Ti); removing a charge quantity in an integration capacitor (CI) of the integrator, each time an output voltage (Vi) of the integrator reaches a reference voltage (Vcr); generating an event in an event signal (EVT) each time the integrator voltage reaches the reference voltage; generating an event count value (DO) by counting the events during an integration period; at the end of the integration period, continuing to generate events; determining a residual time (Tr) from a last event to the end of the integration period; and determining an output digital value corresponding to the input analog signal as a function of the event count value (DO) and the residual time.

Fig. 6

## Description

## TECHNICAL FIELD

The present disclosure relates to measurement of analog signals and more specifically to measurement of currents issued from a sensor by converting such currents into digital samples. The present disclosure relates to the field of analog to digital converters (ADC) and more specifically to integrating ADCs. Integrating ADCs are generally used in applications where a high resolution is required at a comparatively low sample rate.

## BACKGROUND

There is a need for measuring small currents (between 0.1 and 250 nA) with a high resolution (greater than 15 bits), accuracy, a wide dynamic range, high speed, low power consumption, and using a small surface of a die.

At present, there are many varieties of ADC, such as sigma-delta ADC, feedback type ADC, slope or integrating ADC, flash ADC, pipeline ADC and successive approximation register (SAR) ADC. Sigma-delta ADCs have generally a high resolution but are not suitable for high frequency signals and have a high complexity and current consumption. Feedback type and slope and charge redistribution ADCs have generally a low complexity and power consumption and can process medium frequency signals but have a medium resolution. Flash ADCs can process high frequency signals with a low resolution, but have a high complexity and high power consumption.

The present disclosure more specifically relates to a type of slope ADCs operating as a current to frequency converter using the integrate and fire principle. Such an ADC comprises an integrator with an integration capacitor and an integration clock controlling the overall conversion process. After a reset where an integration voltage is set to a reference voltage, an integration starts whereas the integration voltage decreases until it reaches a threshold voltage defined by a comparator which then triggers an event which is counted. The conversion process stops when the time elapsed from the reset time reaches an integration time. At the end of the integration period, a residual charge left in the integration capacitor is discarded. However this residual charge represents a fragment of a counted event. The integration capacitor can be reduced to decrease the potential residual charge. The dynamic range of the ADC can be controlled by adjusting the integration time. However the resolution of the ADC is defined by a logarithm relation applied to a ratio of the integration time and the integration capacity. In practice, the resolution of the ADC can hardly exceed 14 bits.

The document "Fractional charge packet counting with constant relative resolution", A. Nascetti, International Journal of Circuit Theory and Applications, 2012;

Vol. 40, p. 175-187, 23 June 2010 discloses an ADC using the integrate and fire principle and comprising an additional converter discharging a sample/hold capacitor with a constant current and measuring the discharging time of the capacitor by counting clock pulses for measuring the residual charge left in the integration capacitor. This circuit has a complex structure with at least four capacitors and thus needs a large substrate surface Thus, there is a need for increasing the resolution of a slope ADC of the type integrate-and-fire with a wide dynamic range of the input current. There is also a need for a compact ADC having a high sample rate.

## SUMMARY

The present disclosure is related to a method for converting an input analog signal into an output digital value, the method comprising: applying the input analog signal to an integrator for an integration period; removing a charge quantity in an integration capacitor of the integrator, each time an output voltage of the integrator reaches a reference voltage, during the integration period; generating an event in an event signal each time the integrator voltage reaches the reference voltage; counting the generated events in the event signal during the integration period, to obtain an event count value; at the end of the integration period, continuing to apply the input analog signal to the integrator and remove the fixed charge quantity in the integration capacitor each time the output voltage of the integrator reaches the reference voltage and continuing to generate an event in the event signal each time the integrator voltage reaches the reference voltage; determining a residual time from a last event in the event signal to the end of the integration period; and determining an output digital value corresponding to the input analog signal as a function of the event count value, the residual time and an event period.

In this manner, the digital value provided by the method has a higher resolution. In addition, the residual charge in the integration capacitor can be measured without using complex circuits including capacitors.

According to an embodiment, the residual time is measured by a counter providing a residual time count.

According to an embodiment, the residual time is determined by measuring a time from the end of the integration period to a time when the integrator voltage reaches the reference voltage, and by subtracting the measured time from a measured event period to obtain a residual time count.

According to an embodiment, the event period is measured between first and second consecutive events generated when the integrator voltage reaches the reference voltage after the end of the integration period.

According to an embodiment, the output digital value corresponding to the input analog signal is determined from the event count value and a ratio of the residual time count and the measured event period, a least significant bit of the count value having a fractional value equal to the ratio.

According to an embodiment, the charge quantity is removed from the integration capacitor of the integrator using another capacitor having a same capacity as the integration capacitor and which is charged and discharged at the same time as the integration capacitor.

In this manner, the integration is not stopped when the integration capacitor is discharged.

Embodiments may also relate to an analog to digital converter comprising: an integrator comprising an integration capacitor; a circuit for removing a charge quantity from the integration capacitor; a comparator for comparing an integrator output voltage with a reference voltage and generating an event signal; a counter for counting events in the event signal; and a converter receiving the event signal and configured to measure a residual time, the analog to digital converter being configured to implement the method defined above.

According to an embodiment, the converter comprises: a pulse generator receiving the event signal; a counter receiving a clock signal and a pulsed signal from the pulse generator; a register to store a count value provided by the counter; and a divider to divide the value stored in the register by the output value of the counter.

According to an embodiment, the circuit for removing a charge quantity from the integration capacitor comprises a capacitor having a same capacity as the integration capacitor, and which is charged and discharged at the same time as the integration capacitor.

## BRIEF DESCRIPTION OF THE DRAWINGS

The foregoing and other purposes, features, aspects and advantages of the invention will become apparent from the following detailed description of embodiments, given by way of illustration and not limitation, with reference to the accompanying drawings, in which the same reference refer to similar elements or to elements having similar functions, and in which:

Figure 1 is a schematic view of a circuit of a conventional integrate and fire analog-digital converter;
Figure 2 is an operation timing view showing an example of the operation of the analog-digital converter of Figure 1;
Figure 3 is a schematic view of a circuit of an integrate and fire analog-digital converter, according to an embodiment;
Figure 4 is an operation timing view showing an example of the operation of the analog-digital converter of Figure 3, according to an embodiment;
Figure 5 illustrates a concatenation operation of counter values provided by the analog-digital converter of Figure 4 to obtain a final result, according to an embodiment;
Figure 6 is a schematic view of a circuit of an integrate and fire analog-digital converter, according to another embodiment;
Figure 7 is an operation timing view showing an example of the operation of the analog-digital converter of Figure 6, according to an embodiment.

## DETAILED DESCRIPTION

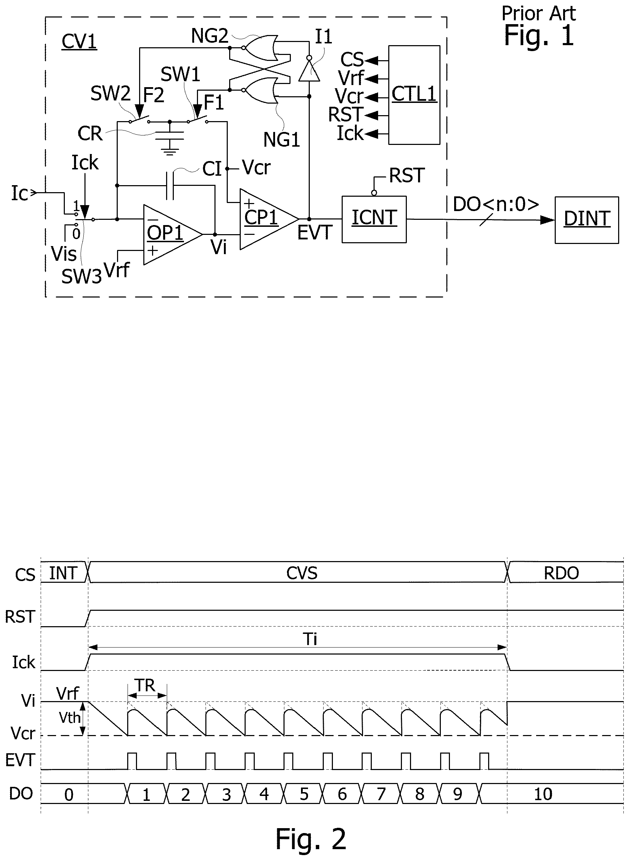

Figure 1 shows a conventional integrate and fire analog-digital converter (ADC) CV1. The ADC CV1 comprises an integrator comprising an operational amplifier OP1 and an integration capacitor CI, a comparator CP1 and an integration counter ICNT, and a controller CTL1. The operational amplifier OP1 comprises a positive input receiving a positive reference voltage Vrf and a negative input connected to a selector SW3 for selecting an input current Ic or a reference voltage Vis. The integration capacitor CI is connected between the negative input and an output of the operational amplifier OP1. The output of the operational amplifier OP1 is connected to a negative input of the comparator CP1. The comparator CP1 comprises a negative input receiving a positive reference voltage Vcr. The comparator CP1 provides an event signal to the counter ICNT. The counter ICNT is set to 0 by a reset signal RST and provides a digital output signal DO to a digital interface DINT. The ADC CV1 further comprises a control circuit CU comprising a reset capacitor CR, switches SW1, SW2, a controller CTL1 and logical gates 11, NG1, NG2. The capacitor CR connected to the ground or the reference voltage source Vrf, linked to the positive input of the comparator CP1 by the switch SW1, and linked to the negative input of the operational amplifier OP1 by the switch SW2. The switches SW1 and SW2 are controlled by respective control signals F1 and F2 provided by the logical circuit comprising two NOR gates NG1, NG2 connected to form a latch, an inverter I1 having an input connected to an input of the gate NG1 and to the output of the comparator CP1 and an output connected to an input of the gate NG2. The output of the gate NG1 provides the control signal F1 and the output of the gate NG2 provides the control signal F2. Thus when the control signal F1 is switched to a low state, the control signal F2 is switched to a high state and reversely. Thus the switches SW1, SW2 are controlled such that they are never closed at the same time, to avoid charge sharing issues. The controller CTL1 can comprise a finite state machine to provide a control signal defining operating phases of the ADC, the voltages Vrf, Vcr and the signals RST, Ick during each operating phase of the ADC.

Figure 2 illustrates the operation of the ADC CV1. Figure 2 shows a control signal CS that controls the ADC, the reset signal RST, the clock signal Ick, the output voltage Vi of the operational amplifier OP1, the reference voltage Vcr, the output signal EVT of the comparator CP1 and the output data DO of the counter ICNT. The control signal CS provided by the controller CTL1 defines an initialization phase INT, an integration phase CVS and reading phase RDO. The duration of the integration phase CVS corresponds to an integration time Ti. During the initialization phase INT, the reset signal RST and the clock signal Ick are set to a low state. The output voltage Vi is set to the reference voltage Vrf using a switch (not shown) to short the integration capacitor. The reference voltage Vcr is set to a low voltage and the digital output signal IA is set to 0. The difference between the references voltages Vrf and Vcr corresponds to a threshold voltage Vth.

The integration phase CVS is triggered by setting the reset signal RST and the clock signal Ick to a high state. Thus the selector SW3 is set to provide the input signal Ic to the negative input of the operational amplifier OP1. During a first integration period, the output voltage Vi of the operational amplifier OP1 follows a decreasing slope until it reaches the reference voltage Vcr. At this time, a reset period is triggered, in which a pulse appears in the output signal EVT of the comparator CP1, the digital output signal DO is set to 1, and a reset of the integration capacitor CI is performed, setting the output voltage Vi to a voltage near the reference voltage Vrf. During a subsequent integration period, the output voltage Vi increases and then follows the decreasing slope until it reaches the reference voltage Vcr. At this time, a reset period is triggered, in which a new pulse appears in the output signal EVT, the digital output signal DO is set to 2, and the output voltage Vi follows the same curve as when it reaches the reference voltage Vcr for the first time. The decreasing slope in the signal Vi is determined by the input current Ic, a larger current meaning a faster discharge and thus steeper slope.

The reset capacitor CR and the controlled switches SW1, SW2 enable to perform a soft reset for discharging the capacitor CI (when the output voltage Vi jumps to a voltage near the reference voltage Vrf. A hard reset consisting in shorting the capacitor CI would interrupt the integration for a brief moment and introduce a large non-linearity. The capacitor CR has a same capacity C as the capacitor CI. When the switch SW1 is closed and the switch SW2 is opened, the capacitor CR is precharged with a charge equal to C*Vth. The capacitor CI receives the same charge at the time the soft reset is triggered. At this time, the charge of the capacitor CI is equal to C*Vth, the switch SW2 is closed and the switch SW1 is opened, so that the charge in the capacitor CR is moved to the capacitor CI with a negative sign to discharge the latter. Thus the charge of the capacitor CI at the end of a soft reset is equal to the current charge of the capacitor CI (= C*Vth + Ic*TS) minus the current charge of the capacitor CR (= C*Vth), TS being the duration of a soft reset operation. Thus the soft resets do not stop the integration.

The readout phase RDO starts at the end of the integration phase. During the readout phase RDO, the reading of the value of the counter ICNT is open. The clock signal Ick is set to low, the output signal Vi is set to Vrf, and the output signal EVT is set to low.

In the example of Figure 2, ten pulses appear in the signal EVT during the integration phase CVS. Therefore, during the readout phase RDO, the value DO of the counter ICNT is equal to 10.

The difference between the output voltage Vi and the reference voltage Vcr at the end of the integration phase CVS corresponds to a residual charge left in the integration capacitor CI and which is discarded. This residual charge corresponds to a part of the input signal Ic which is not considered by the analog-digital conversion and represents a quantization error. This residual charge can be reduced by decreasing the value of the capacitor CI. However this reduction is limited by the parasitic capacitors. In fact, the effective number ENB of bits of the digital output signal IA can be computed by the following equation:

$$ENB = \log_2(Ti \times Im / (CI \times Vth)) \qquad (1)$$

with Im is the maximum value of the input signal Ic. The presence of the function $\log_2$ in this equation shows that it is practically not feasible to increase the resolution of the ADC of Figure 1, e.g. to reach a resolution of 15 bits from a resolution of 14 bits. More generally, a resolution of 15 bits or more in the defined application domain is not achievable with traditional slope architectures using integration and fire principle, due to max event frequency achievable combined with sampling frequency constraints. However, this architecture presents the advantages of having a relatively simple silicon complexity and low power consumption.

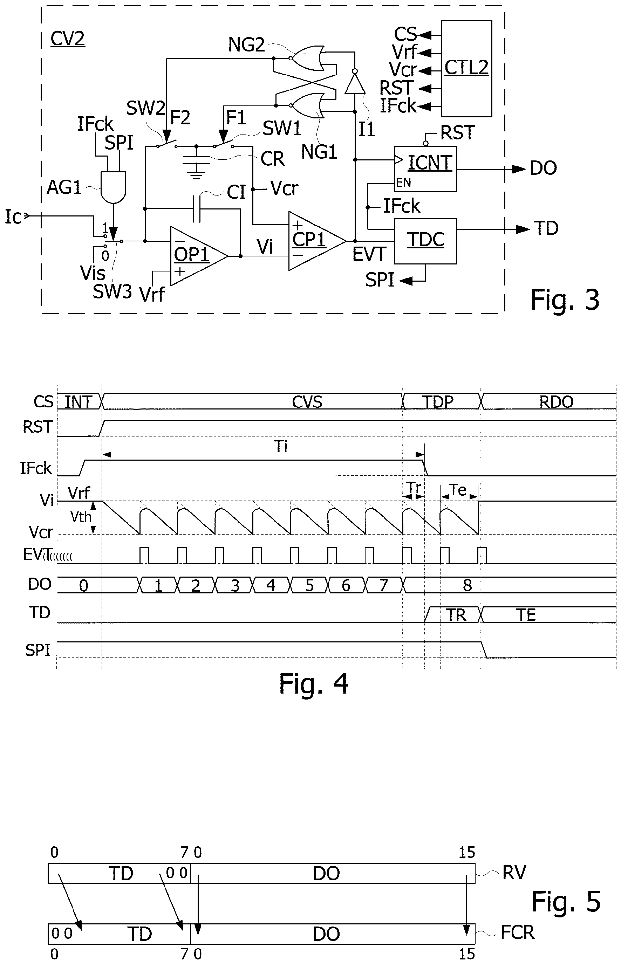

Figure 3 shows an ADC CV2 of the type integrate and fire, according to another embodiment. The ADC CV2 mainly differs from the ADC CV1 in that it further comprises a time to digital converter TDC for converting a time to a digital code to quantize the charge residue left in the integration capacitor CI at the end of the integration phase CVS and a different controller CTL2. The ADC CV2 further comprises an AND gate AG2 receiving signals IFck and SPI and controlling the switch SW3. The signal SPI is provided by the circuit TDC. To convert a time to a digital code, the converter TDC uses a high speed clock signal defining its resolution. The converter TDC receives the output signal EVT of the comparator CP1 and a clock signal IFck. The converter TDC provides a count value TD and the signal SPI to stop the integration phase. An AND gate AG2 controls the switch SW3, from the clock signal IFck and a signal SPI to stop the integration. Thus, the input signal is provided to the ADC CV2 only when both the signals SPI and IFck are in their high state. The controller CTL2 provides the control signal CS defining operating phases of the ADC, the voltages Vrf and Vcr, and the signals RST and IFck.

Figure 4 illustrates the operation of the ADC CV2. Figure 4 shows a control signal CS that controls the ADC, the reset signal RST, the clock signal IFck, the output voltage Vi of the operational amplifier OP1, the reference voltage Vcr, the output signal EVT of the comparator CP1, and the output signals TD and SPI of the converter TDC. The control signal CS defines an initialization phase INT, an integration phase CVS, a conversion phase TDP and a reading phase RDO. During the initialization phase INT the clock signal IFck is set from its low state to its high state. The output voltage Vi is set to the reference voltage Vrf. The reference voltage Vcr is set to a low voltage and the digital output signals DO and TD are set to 0. The integration period (Ti) starts when the signal RST there is set from a low state to a high state and ends when the clock signal IFck is set to a low state during the conversion phase TDP. The behavior of the ADCs CV2 and CV1 are substantially the same until the end of the integration phase CVS.

In the example of Figure 4, eight events (pulses) appear in the signal EVT during the integration phase CVS. Thus during the readout phase RDO, the value DO of the counter ICNT is 8.

The integration is extended during the conversion phase TDP, to measure the voltage residue of the integration capacitor CI in time domain, but the counter ICNT is disabled. Tr represents the time interval between the last event (pulse) in the EVT signal before the end of the integration period Ti and the end of this period (i.e. the time when the clock signal IFck is set to the low state). The last event period of the integration phase CVS ends during the conversion phase TDP and is followed by another event period extending during a time interval Te. The conversion phase TDP ends at the end of the event period Te and is followed by the readout period TDO. Counting performed by the converter TDC starts at the last event in the EVT signal before the end of the integration period Ti to provide a count TR corresponding to the duration of the time interval Tr and a count TE corresponding to the duration of the time interval Te, i.e. the event period of the signal EVT. The signal SPI is in the high state during the phases INT, CVS and TDP, and in the low state during the readout phase RDO. The count value TD provided by the converter TDC is equal to $TR/TE * 2^{TNB}$, TNB being the number of bits of the counter implemented in the converter TDC. The count value TD defines the LSB of the count value DO.

A final result of the converter CV2 can be obtained by shifting right (toward the MSB - Most Significant Bit) the count DO provided by the counter ICNT by the number of bits of the range of the count value TD provided by the converter TDC, and adding to the shifted value the count value TD. The counting performed by the converter TDC to obtain the count value TR can be triggered at each event in the signal EVT, the counter being reset at the beginning of the count.

The converter CV2 presents the advantages of having a low complexity. In addition, no sampling of the input voltage and no calibration are needed. In addition, the converter CV2 can be implemented using the analog part of the hardware of converter CV1.

The time interval Tr can be measured by a counter of the converter TDC, receiving a clock signal of high frequency, which is reset at each event in the event signal EVT and which is stopped at the end of the integration period. Thus at the end of the integration period, the counter provides the count value TR. Then the counter is reset at the next event in the signal EVT and started to count the time interval Te until the subsequent event. At this time the counter contains the count value TE. The value TR can be pushed to a register when the value TE is counted.

Figure 5 illustrates a concatenation operation of the counter values DO and TD provided by the ADC CV2 to obtain a final result, according to an embodiment. Figure 5 shows the raw values RV of the counter values DO and TD. In fact, the counter value TD represents a fraction of the least significant bit (LSB) of the counter value DO.

Then, the digital output count DO provided by the counter ICNT is shifted right and added to the count TD that can be provided by the counter TDC to provide a final result FCR. Thus, the resolution of the ADC is increased by the number of effective bits provided by the count TD provided by the counter TDC. In the example of Figure 5, the counter value DO is provided in a 16-bit word, and the counter value TD is provided in an 8-bit word.

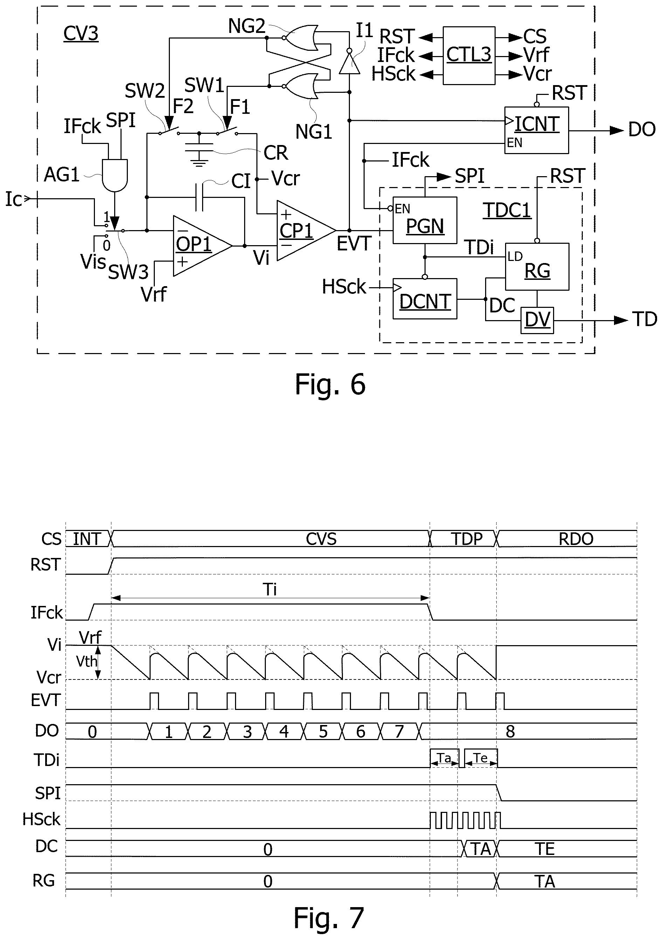

Figure 6 shows an ADC CV3 of the type integrate and fire, according to another embodiment, and more particularly an embodiment TDC1 of the converter TDC of the ADC CV2. The converter TDC1 comprises a pulse generator PGN, a register RG, a counter DCNT and a divider DV. The pulse generator PGN receives the event signal EVT from the comparator CP1 and the clock signal IFck and provides the stop signal SPI and a pulsed signal TDi to a load input LD of the register and to the counter DCNT. The counter DCNT receives a clock signal HSck of high frequency which can be generated by the controller CTL3 of the ADC CV3. The counter DCNT provides a count value DC to a data input of the register RG and to the divider DV. The divider DV comprises another input connected to the register RG and an output providing the output value TD of the converter TDC1.

Figure 7 illustrates the operation of the ADC CV3. Figure 7 shows the control signal CS that controls the ADC, the reset signal RST, the clock signal IFck, the output voltage Vi of the operational amplifier OP1, the reference voltage Vcr, the output signal EVT of the comparator CP1, and the output signals TDi and SPI of the generator PGN, the clock signal HSck, the output DC of the counter DCNT and the content of the register RG. The control signal CS defines an initialization phase INT, an integration phase CVS, a conversion phase TDP and reading phase RDO. The signals CS, RST, IFck, Vi, Vcr, EVT, SPI and ICNT are substantially the same as in Figure 4. The signals TDi, HSck are in a low state and values DC and RG are equal to 0 during the phases INT and CVS.

The integration is extended during the conversion phase TDP, to measure the voltage residue of the integration capacitor CI in time domain, but the counter ICNT is disabled. The clock signal IFck is set to its low state at the beginning of the conversion phase TDP. At this time, the pulse generator PGN generates a first pulse of duration Ta and ending at the occurrence of a first pulse in the signal EVT after the beginning of the conversion phase TDP. Then the pulse generator PGN generates a second pulse of duration Te and ending at the occurrence of a second pulse in the signal EVT after the beginning of the conversion phase TDP. The pulse duration Ta is measured by the counter DCNT and the counted value TA is stored in the register RG. The pulse duration Te is further measured by the counter DCNT and the counted value TE is provided to the divider DV with the content TA of the register RG. The signal TDi provided by the pulse generator PGN to the counter DCNT act as an enable signal of the counter DCNT. As long as a pulse (Ta or Te) is present, the counter DCNT is increased at each pulse of the clock signal HSck. Therefore, the counter values TA and TE correspond respectively to the time duration Ta, Te divided by the period of the clock signal HSck. The resolution of the measures TA and TE is equal to the period of the clock signal HSck. The divider DV provides the ratio R = TA/TE. Finally, the quantity $(1 - R) * 2^{TNB}$ defines the LSB of the count value DO and the LSBs of the conversion result, TNB being the number of bits of the counter TCNT.

The frequency of the clock signal HSck is at least five times and the frequency of the event signal EVT to measure the time intervals Tr or Ta and Te with a sufficient resolution. Indeed, the ratio of the frequencies of the signals HSck and EVT determines what the resolution of the circuit TDC, TDC1. Since the frequency of the signal EVT depends on the input signal (it is lower when the input signal is smaller), this means that the resolution of the circuit TDC, TDC1 is higher for lower input currents. Thus, the resolution improvement can be calculated as log2(1/2*Te_max/THSck), where Te_max is the period reached when the input current is maximum, and THSck is the period of the clock signal HSck. The factor 1/2 appears because two measurements (Ta and Te) are performed, doubling the error. The above equation can also be expressed as log2(TE/2). In fact, when the input signal is maximum, TE reached its minimum value and thus can be used to calculate resolution.

The final result FCR of the converter CV4 can be obtained by shifting right (toward the MSB) the count DO provided by the counter ICNT by the number of bits TNB of the range of the count value TD provided by the converter TDC1, and adding the count value TD to the shifted value.

The above description of various embodiments is provided for purpose of description to one of ordinary skills in the related art. It is not intended to be exhaustive or to limit the scope of the present disclosure solely to the disclosed embodiments. Numerous alternatives or variations to the present disclosure will be apparent to those of ordinary skills in the related art. Accordingly, while some alternatives or embodiments have been presented specifically, other embodiments will be apparent or easily developed by those of ordinary skills in the related art. Limitations in the appended claims should be interpreted broadly based on the language used in the claims and such limitations should not be restricted to the specific examples described above.

In this respect, it is apparent to those of ordinary skills in the related art that other ways than a counter to measure the residual time may be implemented. For example, at the end of the integration period, the input signal Ic is disconnected. At this point there is a voltage residue in the capacitor. Then, a known constant current source Vis is connected to the input of the integrator to keep the capacitor CI discharging. The converter TDC uses a counter to measure the time Ta between the instant when the current source is enabled and the next event in the event signal EVT. Thus the count value TA can be obtained. Then, the duration of the interval from this event and the next event is also measured to obtain the count value TE.

The residual charge in the integration capacitor may correspond to more than one bit of the event count value DO. This case may arise if the integration capacitor CI is not reset when the stored voltage Vi reaches the threshold Vcr. In this case, the integration continues beyond the threshold and the residual charge in the capacitor CI will correspond to more than the least significant bit of the count value DO.

In addition, the use of the capacitor CR is optional, and the integration capacitor can be alternatively initialized by connecting its terminals together using a controlled switch.

## Claims

1. A method for converting an input analog signal into an output digital value, the method comprising:

   applying the input analog signal (Ic) to an integrator (OP1-CI) for an integration period (Ti);
   removing a charge quantity in an integration capacitor (CI) of the integrator, each time an output voltage (Vi) of the integrator reaches a reference voltage (Vcr), during the integration period;
   generating an event in an event signal (EVT) each time the integrator voltage reaches the reference voltage;
   counting the generated events in the event signal during the integration period, to obtain an event count value (DO);
   at the end of the integration period, continuing to apply the input analog signal to the integrator and remove the fixed charge quantity in the integration capacitor (CI) each time the output voltage of the integrator reaches the reference voltage and continuing to generate an event in the event signal (EVT) each time the integrator voltage reaches the reference voltage; determining a residual time (Tr) from a last event in the event signal to the end of the integration period; and determining an output digital value corresponding to the input analog signal as a function of the event count value (DO), the residual time and an event period (Te).

2. The method of claim 1, wherein the residual time (Tr) is measured by a counter providing a residual time count (TR).

3. The method of claim 1, wherein the residual time (Tr) is determined by measuring a time (Ta) from the end of the integration period (Ti) to a time when the integrator voltage (Vi) reaches the reference voltage (Vcr), and by subtracting the measured time (TA) from a measured event period (TE) to obtain a residual time count (TR).

4. The method according to one of claims 1 to 3, wherein the event period (Te) is measured between first and second consecutive events generated when the integrator voltage (Vi) reaches the reference voltage (Vcr) after the end of the integration period (Ti).

5. The method according to claim 1, wherein the output digital value (FCR) corresponding to the input analog signal (Ic) is determined from the event count value (DO) and a ratio (TD) of the residual time count (TR) and the measured event period (TE), a least significant bit of the count value having a fractional value equal to the ratio.

6. The method according to one of claims 1 to 5, wherein the charge quantity is removed from the integration capacitor (CI) of the integrator using another capacitor (CR) having a same capacity as the integration capacitor and which is charged and discharged at the same time as the integration capacitor.

7. An analog to digital converter comprising:

   an integrator (OP1-CI) comprising an integration capacitor (CI);
   a circuit (Cr-SDW1-SW2) for removing a charge quantity from the integration capacitor;
   a comparator (CP1) for comparing an integrator output voltage (Vi) with a reference voltage (Vcr) and generating an event signal (EVT);
   a counter (ICNT) for counting events in the event signal; and
   a converter (TDC, TDC1) receiving the event signal and configured to measure a residual time (Te), the analog to digital converter being configured to implement the method according to one of claims 1 to 6.

8. The analog to digital converter of claim 7, wherein the converter (TDC1) comprises:

   a pulse generator (PGN) receiving the event signal (EVT);
   a counter (DCNT) receiving a clock signal (HSck) and a pulsed signal from the pulse generator;
   a register (RG) to store a count value (TR, TA) provided by the counter; and
   a divider (DV) to divide the value stored in the register by the output value of the counter.

9. The analog to digital converter according to claim 7 or 8, wherein the circuit (Cr-SW1-SW2) for removing a charge quantity from the integration capacitor comprises a capacitor (CR) having a same capacity as the integration capacitor (Ci) and which is charged and discharged at the same time as the integration capacitor.

Prior Art
Fig. 1

CS
INT | CVS | RDO

RST

Ti

Ick

Vi | Vrf
Vth
Vcr

EVT

DO | 0 | 1 | 2 | 3 | 4 | 5 | 6 | 7 | 8 | 9 | 10

Fig. 2

Fig. 3

Fig. 4

Fig. 5

Fig. 6

Fig. 7

Europäisches
Patentamt

European
Patent Office

Office européen
des brevets

# EUROPEAN SEARCH REPORT

**Application Number**

EP 24 30 5471

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/170190 A1 (TRINAMIX GMBH [DE]; CONSEJO SUPERIOR INVESTIGACION [ES] ET AL.) 14 September 2023 (2023-09-14) * pages 11,22; figures 1,2 * | 1-9 | INV. H03M1/06 H03M1/14 H03M1/60 H03M3/00 |
| L | DEI MICHELE ET AL: "Highly linear integrate-and-fire modulators with soft reset for low-power high-speed imagers", 2017 IEEE INTERNATIONAL SYMPOSIUM ON CIRCUITS AND SYSTEMS (ISCAS), IEEE, 28 May 2017 (2017-05-28), pages 1-4, XP033156074, DOI: 10.1109/ISCAS.2017.8050411 [retrieved on 2017-09-25] | 1-9 | |
| X,D | NASCETTI A: "Fractional charge packet counting with constant relative resolution", INTERNATIONAL JOURNAL OF CIRCUIT THEORY AND APPLICATIONS, JOHN WILEY & SONS, INC, HOBOKEN, USA, vol. 40, no. 2, 22 June 2010 (2010-06-22), pages 175-187, XP071448136, ISSN: 0098-9886, DOI: 10.1002/CTA.714 * Section 3.4; figures 1,2,6 * | 1-9 | |

**TECHNICAL FIELDS SEARCHED (IPC)**

H03M

The present search report has been drawn up for all claims

| Place of search | Date of completion of the search | Examiner |
|---|---|---|
| The Hague | 15 October 2024 | Jesus, Paulo |

EPO FORM 1503 03.82 (P04C01)

**ANNEX TO THE EUROPEAN SEARCH REPORT
ON EUROPEAN PATENT APPLICATION NO.**

EP 24 30 5471

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2024

| Patent document cited in search report | Publication date | Patent family member(s) | Publication date |
|---|---|---|---|
| WO 2023170190 A1 | 14-09-2023 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. NASCETTI**. Fractional charge packet counting with constant relative resolution. *International Journal of Circuit Theory and Applications*, 23 June 2010, vol. 40, 175-187